# EUROPEAN PATENT APPLICATION

(11) **EP 4 105 664 A1**
(43) Date of publication of application: **21.12.2022**
(21) Application number: 21180086.7
(22) Date of filing: 17.06.2021
(51) Int. Cl.: G01R 1/02, G01R 1/04, G01R 31/34

(54) **TRANSPORTABLE TESTING ARRANGEMENT**

(71) Applicant: Proventia Oy, 90460 Oulunsalo (FI)
(72) Inventor: Kallio, Teemu, 90460 Oulunsalo (FI); Uusitalo, Matti, 90460 Oulusalo (FI); Lakso, Mika, 90460 Oulunsalo (FI); Kervinen, Harri, 90460 Oulunsalo (FI); Arponen, Toni, 90460 Oulunsalo (FI); Garratt, Chris, Leighton Buzzard, LU7 3JA (GB); Holopainen, Erkki, 90460 Oulunsalo (FI); Lapinoja, Miro, 90460 Oulunsalo (FI); Ylimäki, Kai, 90460 Oulunsalo (FI); Kujala, Jaakko, 90460 Oulunsalo (FI); Paavola, Mika, 90460 Oulunsalo (FI); Pasanen, Tarmo, 90460 Oulunsalo (FI); Vilmusenaho, Mika, 90460 Oulunsalo (FI)
(74) Representative: Kolster Oy Ab

(57) **Abstract**

A transportable testing arrangement comprising a testing area configured to receive an electric component to be tested, a removable hood configured to cover the testing area, testing equipment for testing the electric component, a base on which the testing area, the removable hood and at least part of the testing equipment are mounted and a frame on which the base is mounted. The base further comprises at least a part of at least one wall of the removable hood having at least a part of one or more inlets to couple the testing equipment with the electric component.

## Description

### Field

The invention relates to a field of testing arrangements, especially transportable testing arrangements.

### Background

Testing of products is an essential part of manufacturing activities. The testing arrangements are often complicated and need a lot of space in manufacturing facilities and hence, adjusting of the testing capacity to meet the actual needs may be challenging. Current solutions for adjusting of the testing capacity may not be effective especially in cases where the testing arrangements are complicated and large like, for example, in testing of electric motors of vehicles.

Hence, there is a need for a sophisticated solution that can be used to adjust the testing capacity according to the changing needs.

### Brief description

The present invention is defined by the subject matter of the independent claim.

Embodiments are defined in the dependent claims.

The embodiments and features, if any, described in this specification
that do not fall under the scope of the independent claim are to be interpreted as examples useful for understanding various embodiments of the invention.

### List of drawings

Example embodiments of the present invention are described below, by way of example only, with reference to the accompanying drawings, in which
Figures 1, 2, 3, 4 and 7 illustrate a transportable testing arrangement according to embodiments of the invention; and
Figures 5A, 5B and 6 illustrate a removable hood of the transportable testing arrangement according to embodiments of the invention.

### Description of embodiments

The following embodiments are only examples. Although the specification may refer to "an" embodiment in several locations, this does not necessarily mean that each such reference is to the same embodiment(s), or that the feature only applies to a single embodiment. Single features of different embodiments may also be combined to provide other embodiments. Furthermore, words "comprising" and "including" should be understood as not limiting the described embodiments to consist of only those features that have been mentioned and such embodiments may contain also features/structures that have not been specifically mentioned. All combinations of the embodiments are considered possible if their combination does not lead to structural or logical contradiction.

Testing of electric components in a field of the vehicles requires often complex testing arrangements. The electric components may refer, for example, electric motors of the vehicles. Because of the complex structure of the testing arrangement, adjusting a testing capacity to meet a changing demand may be challenging and time consuming. The invention provides a solution to alleviate the above mention challenges.

According to an aspect, there is provided a transportable testing arrangement comprising a testing area configured to receive an electric component to be tested, a removable hood configured to cover the testing area, testing equipment for testing the electric component, a base on which the testing area, the removable hood and at least part of the testing equipment are arranged and a frame on which the base is arranged, wherein the base further comprises at least a part of at least one wall of the removable hood having at least a part of one or more inlets to couple the testing equipment with the electric component.

The term "transportable testing arrangement" refers to the test setup that comprises all the necessary arrangement for testing the electric component. The test arrangement is built on the frame (platform) such that the entire testing arrangement can be moved from one location to another. The transportable testing arrangement can be transported to the desired location, for example, inside the production facilities wherein needed connections (electricity etc.) are made and the testing arrangement is ready to use.

The term "arranged" may refer that some parts/components are coupled removably and/or fixedly together.

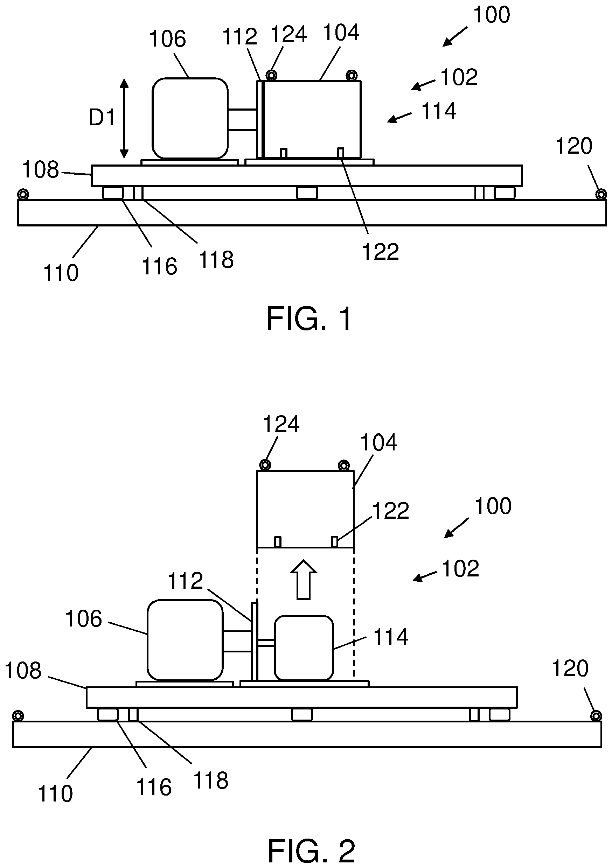

Referring to Figure 1, in an embodiment, the transportable testing arrangement comprises the testing area 102 configured to receive the electric component 114 to be tested. The testing area 102 is covered by the removable hood 104. The testing area is not visible in Figure 1 since it is covered by the removable hood. Figure 2 illustrates the transportable testing arrangement 100 such that the removable hood 104 is lifted up and the testing area 102 with the electric component 114 is visible. The testing area refers to a place of the testing arrangement to which the electric component(s) is placed in the testing. In an embodiment, the testing area may comprise a fixture (test bench) for the electric component configured to receive the electric component. The fixture may be lockable mechanism used to lock and unlock the electric component. Locking of the electric component prevents movement of the electric component during the testing and respectively unlocking releases the electric component allowing, for example, changing of the electric component when the testing is completed. The testing area may comprise also other components than the fixture.

In an embodiment, the electric component is on a pallet (tray) when it is placed into the testing area for testing. If fixture is used, the pallet with the electric component may be placed in the fixture. The pallet may enable easier movement of the electric components in the testing and/or production facilities. The electric component may be fastened to the pallet and the pallet may be fastened to the testing area (fixture). When the electric component to be tested is changed, the pallet is released form the fixture and the new pallet with the electric component is placed into the testing area.

Referring to Figure 1, the removable hood 104 is configured to cover, at least partly, the testing area 102 during testing such that the electric component 114 is substantially inside the hood 104. The removable hood can be removed when testing is completed, and then the electric component can be changed. The removable hood is used to protect, for example, operators who are operating the testing arrangement.

Referring to Figure 1, the transportable testing arrangement 100 comprises test equipment 106 used for testing the electric component. The test equipment 106 is coupled with the electric component 114 placed inside the removable hood 104. The test equipment may vary according to the needs. In an embodiment, the test equipment comprises a dynamometer configured to verify properties of the electric component like, for example, the electric motor of the vehicle. Using of the dynamometer in the field of the testing of the electric motors is widely known and can be seen obvious to the skilled person and hence, it is not discussed in detail in this application.

Referring to Figure 1, the transportable testing arrangement 100 comprises the base 108 on which the testing area 102, the removable hood 104 and at least part of the testing equipment 106 are mounted. In other words, the base is a mounting platform for the test equipment and the electric component to be tested. The base comprises the testing area configured to be covered by the removable hood during the testing such that the hood is, at least partly, coupled with the base.

The transportable testing arrangement further comprises the frame on which the base is mounted. Still referring to Figure 1, the base 108 is mounted on the frame 110. The frame 110 is a bottom element of the transportable testing arrangement and when the testing arrangement is placed, for example, on the floor of the testing facilities, a lower surface of the frame is towards (against) the floor. The lower surface refers to the surface of the frame that is opposite to the surface to which the base is mounted. Hence, a structure of the transportable testing arrangement comprises the frame, which is the bottom element of the structure and the base which is mounted on the top of the frame. The testing equipment, testing area for receiving the electric component and the removable hood are mounted, at least partly, on the base. This structure is illustrated, for example, in Figures 1 and 2.

The base further comprises at least a part of at least one wall of the removable hood. Referring to Figure 2, the at least one wall 112 of the removable hood 104 is mounted the base 108 such that when the hood 104 is removed the wall stays in the base. Hence, the term "wall mounted on the base" in this case refers to the wall that stays in the base when the hood is removed. Figure 2 illustrates a structure wherein the whole one wall of the removable hood is in the base, but it is also possible that just a part of the wall is in the base. The wall mounted on the base may not necessarily refer only to the side wall(s) of the hood. For example, a bottom of the removable hood may be mounted on the base such that when the hood is removed, the bottom stays in the base. In an embodiment the bottom of the removable hood and at least a part of the one or more (side) walls of the removable hood are mounted on the base. The bottom and the at least a part of the one or more side walls of the removable hood may be coupled together forming a part of the hood that stays in the base when the removable hood is removed from the base. In an embodiment, the bottom and at least a part of each side wall of the hood is mounted on the base.

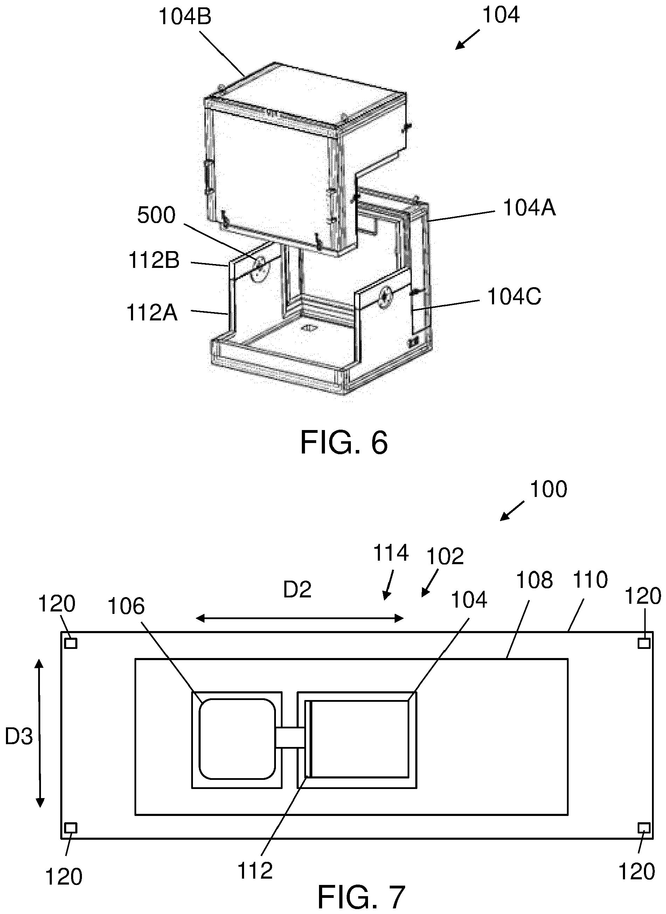

Referring to Figure 6, in an embodiment, the removable hood 104 comprises a plurality of parts 104A - C forming the hood. For example, the bottom of the hood and at least a part of the one or more side walls may be coupled together and mounted on the base forming the first part of the hood 104C. This part 104C stays in the base when the hood is removed. A first side wall comprising at least a part of the other one or more side walls may form the second part of the hood 104A. A second side wall comprising at least a part of the other one or more side walls may form the third part of the hood 104B. The second and the third parts of the hood may be removable and both or at least one of them is/are removed when opening the hood to get access to the electric component to be tested. As described above, the first part of the hood 104C may stay in the base. At least a part of the one or more inlets may be placed on the first part of the hood 104C. In an embodiment the second and the third part of the hood also comprises at least a part of the one or more inlets. The base is not illustrated in Figure 6.

The structure of the hood having a plurality of parts enables easier handling of the hood when assembling and/or removing the hood from the base because the removable part of the hood can be removed in parts. This is the case especially when the hood is large and heavy.

In an embodiment, the wall mounted on the base having at least one inlet comprises two parts. Referring to Figure 6, the wall 112 mounted on the base comprises a first part 112A and a second part 112B wherein the first and the second parts are removably coupled together. The first and the second parts may stay in the base when the hood is removed. The one or more inlets 500 may be arranged into the wall 112 such that a first half of the inlet 500 is in the first part of the wall 112A and a second half of the inlet 500 is in the second part of the wall 112B. When the first and the second part of the wall 112A - B are separated from each other, also the first and the second half of the inlet are separated. Then couplings/connections connecting the test equipment and the electric component together may be assembled into the inlet.

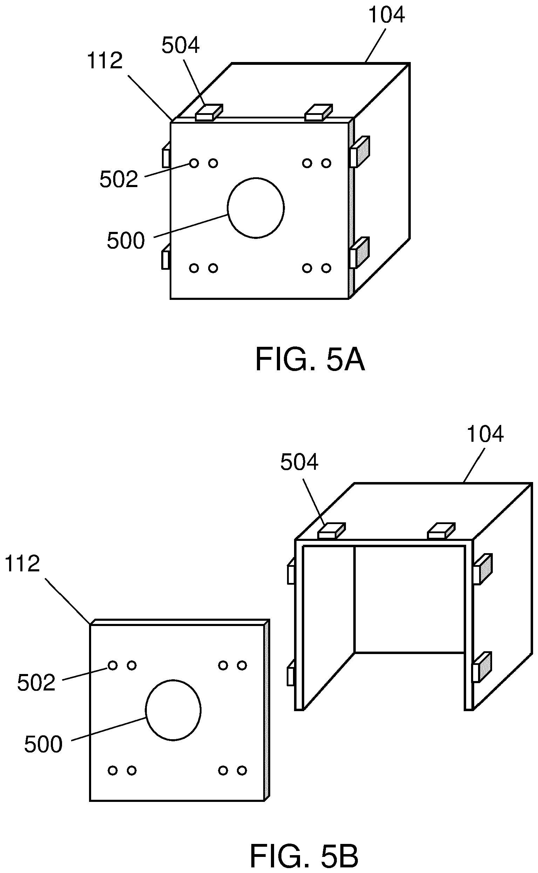

In an embodiment, the wall of the removable hood that is mounted on the base comprises at least a part of the one or more inlets to couple the testing equipment with the electric component. The inlets are for coupling connections between the test equipment with the electric component, in other words, the connections can be guided through the inlets. Referring to Figures 5A and 5B, the wall 112 of the removable hood 104 mounted on the base 108 (base not illustrated in Figures 5A - 5B) comprises the one or more inlets 500, 502. In addition to the inlets 500, 502 in the wall 112 mounted on the base, the removable hood 104 may also comprise inlets to couple the test equipment 106 with the electric component 114. In other words, the part of the removable hood that is removed from the base may also comprise inlets. In an embodiment, a first part of the inlet may be in the wall mounted on the base and a second part of the inlet may be in the removable hood, this embodiment is not illustrated in Figures. For example, a first half of the inlet 500 may be in the wall mounted on the base and a second half of the inlet 500 may be in the removable hood.

A technical effect of the structure in which the at least one wall (or part of it) having the one or more inlets is mounted in the base is that there are no needs to assemble the couplings through the inlet(s) when changing the electric component. The couplings from the test equipment can be just connected to the electric component without guiding them thought the inlet(s) every time when moving the removable hood and changing the electric component to be tested. The arrangement reduces excess work when changing the electric component to be tested and hence, make the testing faster.

As already discussed above, the transportable testing arrangement provide the efficient and effortless solution to adjust the testing capacity to meet the actual needs. The transportable testing arrangement can be transported into the desired location and when coupled with the external couplings like, for example, an electricity network it is ready to use. Therefore, the invention solves the many drawback of the known solutions.

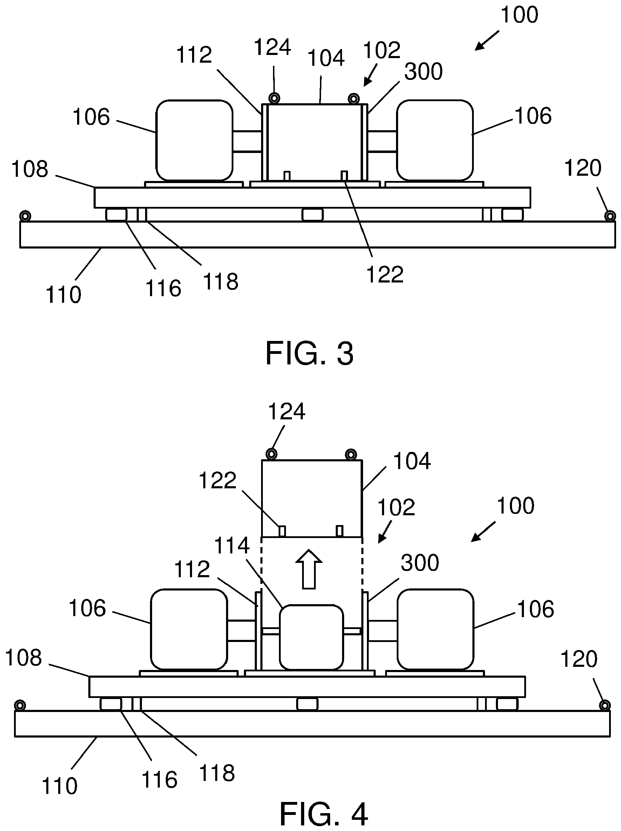

In an embodiment, the base further comprises at least a part of two walls of the removable hood such that each wall has at least a part of one or more inlets to couple the testing equipment with the electric component. Referring to Figure 3 and 4, two walls 112, 300 of the removable hood are mounted on the base. Both walls 112, 300 may comprise the one or more inlets like illustrated in Figure 5A and 5B. Figures 3 and 4 illustrates the transportable testing arrangement according to an embodiment, wherein the test equipment 106 comprises two devises used for testing the electric component. As discussed above the testing equipment may be the dynamometer, for example. Hence, the test equipment may comprise two dynamometers placed on the opposite sides of the testing area (electric component). The test devices may also be arranged differently in the base, they may be arranged to be in adjacent sides of the testing area instead of the opposite sides, for example. In an embodiment, at least one of the two walls comprise the one or more inlets.

Figure 4 illustrates the situation wherein the removable hood 104 is lifted up and the two opposite walls 112, 300 are mounted on the base 108. Both walls 112, 300 may have inlets for coupling the test devices 106 with the electric component 114. The structure and working principle of the second wall 300 mounted in the base is substantially same as with the first wall 112.

In an embodiment, the base comprises at least a part of three walls of the removable hood such that at least some of the walls comprises inlets to couple the test equipment with the electric component.

In an embodiment, the base is mounted to the frame by one or more suspension elements configured to enable movement of the base in relation to the frame. Referring to Figure 1, the base 108 is coupled with the frame 110 by one or more suspension elements 116. The suspension elements allow movement of the base in relation to the frame such that the suspension elements damp the vibration of the base caused by the testing of the electric component. For example, if the testing equipment comprises dynamometer(s) used of testing the electric motor of the vehicle, the testing process may produce vibration. The vibration may be problematic since it may move the testing arrangement if not dampen. As discussed above, the transportable testing arrangement can be placed, for example, on the floor of the testing facility without any fastenings. Therefore, it is essential to dampen the vibration between the base and the frame. The base and the frame having the suspension elements between them make possible to achieve the agile structure of the invention wherein the testing arrangement is possible to place on the floor without any fastenings.

In an embodiment, the one or more suspension elements comprise an air spring. The air spring(s) between the base and the frame enables an air suspension which is very effective solution to damp the vibration. For example, the air springs may be flexible bellows that are inflated by a compressor enabling the dampen effect. The air spring(s) may be inflated already when manufacturing the transportable testing arrangement. It is also possible to inflate the air spring(s) when the testing arrangement is taken in use in the testing location. The air spring may also be deflated, for example, because of the transportation.

In an embodiment, the transportable testing arrangement is configured to receive one or more locking elements configured to prevent movement of the base in relation to the frame in the transportation. Referring to Figure 1, the testing arrangement 100 comprises features configured to receive the one or more locking elements 118. As discussed above, the testing arrangement comprises the one or more suspension elements allowing the movement between the base and frame. The locking elements is configured lock the base and the frame together such that the movement between them is prevented. The locking is needed, for example, when transporting the testing arrangement. The locking of the base and the frame together enables safe transportation. The movement of the base in relation to the frame is dangerous during the transportation and may even break the arrangement, therefore is shall be prevented. For example, the base and the frame may comprise one or more holes that are aligned such that a threaded rod can be assembled to the holes. One or more nuts may be used to tighten the threaded rod such that the base and the frame are locked together preventing their movement in relation to each other. The hole in the base and/or in the frame may also comprise threads.

In an embodiment, a support element is arranged between the base and the frame when locking the base and the frame together by the locking elements. For example, when locking the base and the frame together, the support element is arranged between them and air from the air spring(s) is removed. When the air is removed, the base moves down against the support element and the base and the frame can be locked together by the locking element(s). The support element may be a separated element, or it may be integrated in the testing assembly. The support element may be made of wood and/or rubber, for example.

In an embodiment, transportable testing arrangement comprises the one or more locking elements configured to prevent movement of the base in relation to the frame in transportation. The testing arrangement may comprise, for example, a releasable locking mechanism to lock/unlock the base and frame together such that the movement between them is prevented when needed.

For example, the above mentioned threaded rod may be integrated in the frame such that it goes through the hole arranged in the base. A size of the hole may be dimensioned such that the movement between the base and the frame is possible and the suspension element can damp the vibration between them when the base and the frame are not locked together. When the base and the frame are locked together, the nut is assembled to the threaded rod and tightened pressing the base and the frame together. Air may be removed from the air spring before tightening. In addition, the support element may be arranged between the base and the frame as discussed above. A washer may also be used with the nut.

In an embodiment, the one or more inlets are configured to receive a mechanical transmission element from the testing equipment to the electric component. As described above, the testing equipment may comprise the dynamometer. The dynamometer may comprise a rotating axle (mechanical transmission element) configured to transmit force (torque) between the dynamometer and the electric component to be tested. At least one inlet is configured to receive the rotating axle. As discussed above, mounting the at least part of the wall having the inlet in to the base make easier to change the electric component to be tested since there are no needs to route the coupling through the inlets when the removable hood is lifted up. This is the case especially with the rotating axle that is a rigid structure. It may be difficult and time-consuming task to install the removable hood and route the rigid axle through the inlet. The one or more inlets 500 configured to receive the mechanical transmission element is illustrated in Figures 5A - B.

In an embodiment, the one or more inlets are configured to receive a sensor element from the testing equipment to the electric component. The sensor element may be, for example, any kind of sensor configured to measure properties of the electric component to be tested. The sensor may comprise a wire or a cable that is routed through the one or more inlet. The one or more inlets 502 configured to receive the sensor element is illustrated in Figures 5A -B.

In an embodiment, the inlet(s) comprises a gasket to seal the interface.

In an embodiment, the arrangement further comprises one or more lifting points for coupling lifting means to the arrangement. Referring to Figure 1 and 7, the testing arrangement 100 may comprise lifting point(s) 120 to couple the lifting means with the arrangement. The lifting point(s) 120 may be in the frame 110, for example, in vicinity of each corner of the frame 110. The lifting point may be a lifting lug for coupling a lifting cable, for example. The lifting point may be removable. The lifting means refers to lifting device that is suitable to lift and move the transportable testing arrangement.

In an embodiment, the removable hood comprises a climate hood. The climate hood is configured to create a chamber (enclosure) in the testing area wherein specific environmental conditions can be created inside the hood. The climate hood enables exposing of the electric component(s) to the desired environmental conditions (stress) during the testing. For example, temperature, relative humidity and/or pressure (under/over) may be controlled inside the climate hood. In addition, a salt spray, UV-radiation and/or rain conditions may be created inside the hood, for example. The environmental conditions may also vary inside the hood. For example, the temperature and/or humidity conditions may vary over time in predetermined cycles. The climate hood may be thermally isolated. In addition, the climate hood may be sealed such that it keeps humidity/water inside the hood. Hence, there may be a sealing interface between the wall of the hood that is mounted on the base and between the hood and the base. The Climate hood may comprise an inlet(s) and/or outlet(s) for creating the environmental conditions inside the hood. For example, there may be the inlet and outlet for heated or cooled air.

In an embodiment, the removable hood is sealed to the base and or the wall of the hood mounted on the base such that the environmental conditions stay inside the hood. For example, the inlets of the removable hood are also sealed when using the climate hood.

In an embodiment, the removable hood comprises a projectile protection. For example, the electric component to be tested may be the electric motor of the vehicle that may be faulty. When the faulty electric motor is stressed in the test, it may get broken such that it causes flying splinters (projectiles). The hood is configured to prevent, at least partly, flying of the splinters form inside of the hood. There may be one or more layers in each wall of the hood that are configured to prevent penetration of the walls of the hood by the splinters. The one or more layers may be made of stainless steel, for example. The splinter protection protects the test operators if the electric component breaks in the testing and causes the splinters.

In an embodiment, the removable hood comprises a fire protection. The fire protection is configured to prevent spreading of fire from inside of the removable hood. The removable hood may made of uninflammable materials that do not sustain fire. Hence, the removable hood may be uninflammable, and it further prevents spearing of fire from the hood.

In an embodiment, the fire protection comprises a fire detector and/or a fire alarm for detecting and indicating fire inside the removable hood. In an embodiment, the fire protection may further comprise means for fire extinguishing (fire suppression) inside the removable hood. The fire extinguishing substance may be a dry chemical, a foam or water, for example. There may be a connection (inlet) in the hood for feeding the fire extinguishing material inside the hood, for example, when the fire detector detects the fire inside the hood. The removable hood may further comprise outlets for leading gases (smoke etc), caused by fire, out of the hood and the testing facility. Then the operators are not exposed for the gases caused by the fire.

In an embodiment, the removable hood is movably coupled with the base. For example, the hood may be coupled with the base and/or the testing arrangement with rails such that when the hood is removed from the testing area, it slides on the rails. Then the hood is coupled with the testing arrangement also when it is not in use and placed in the testing area. The removable hood may slide on the rails vertically or horizontally. This enables easier handling of the hood. The hood and/or the rails may further comprise a locking mechanism to lock the hood to the certain position on the rails, for example, such that it is locked when the testing area is covered by the hood.

In an embodiment, the removable hood and/or the at least a part of the at least one wall mounted in the base comprise one or more fasteners to fasten the removable hood with the at least a part of the at least one wall of the removable hood mounted on the base. Further the removable hood and or the base may comprise one or more fasteners to fasten the removable hood into the base. Referring to Figure 1, the removable hood 104 and/or the base 108 comprise one or more fasteners 122 to fasten the removable hood with the base, for example, during the testing. Referring to Figures 5A - B, the removable hood 104 and/or the wall 112 mounted on the base comprises the one or more fasteners 504 configured to fasten the wall 112 mounted in the base 108 with the hood 104. The fasteners may be configured to be opened and closed without tools. The fasteners may be, for example, an adjustable toggle latch kind of fasteners.

In an embodiment, the removable hood comprises one or more lifting points for coupling lifting means to the removable hood. Referring to Figure 1, the removable hood 104 comprises one or more lifting points 124 like, for example, the lifting lugs for coupling the lifting means to the hood 104. The lifting means are used to move the removable hood, for example, when changing the electric component to be tested.

In an embodiment, the arrangement comprises means for adjusting distance between the testing equipment and the electric component. Referring to Figure 1 and 7, the adjustable distance between the electric component 114 and the test equipment 106 is illustrated by arrows D1 - D3. The distance may be adjustable at least in one of the directions D1 - D3. The direction D1 illustrated in Figure 1 refers to a vertical direction, in other words, the testing equipment and the electric component may be moved up and down in relation to each other. The directions D2 and D3, illustrated in Figure 7, refer to a horizontal movement between the electric component and the test equipment. Figure 7 illustrates the testing arrangement from a top view. For example, D2 may refer to a longitudinal direction of the testing arrangement and D3 may refer to a width direction of the testing arrangement.

Nevertheless, the adjustable distance is mentioned between the testing equipment and the electric component, it may also refer to the distance between the testing equipment and the testing area, for example. The point of the adjustment is that the distance between the testing equipment and the electric component may be adjusted that enables testing of electric components having different sizes and shapes, for example.

In an embodiment, the means for adjusting the distance may comprise a plurality of fastening holes in the testing arrangement (in the base) allowing to choose the optimal location for the testing area, the test equipment, the electric component, the fixture in the testing area and/or the removable hood. The above mentioned components may be fastened to the holes by screws or bolts, for example.

In an embodiment, the means for adjusting the distance may comprise rails configured to allow movement of the testing area, the test equipment, the electric component, the fixture in the testing area and/or the removable hood on the rails, for example. The means for adjusting the distance may further comprise the locking means for locking above mentioned component/parts of the testing arrangement in the desired position on the rails.

In an embodiment, the hood may further comprise a transparent window for supervising visually the testing procedure. The window may be configured to meet all the requirement of the hood mention in this application.

In an embodiment, the testing arrangement is configured to receive a plurality of the removable hoods having different properties. For example, the testing arrangement may be configured to receive the hood having the splinter protection without possibility to control environmental properties inside the hood (no climate hood properties). This hood may be used when there are no needs for environmental testing, but the splinter protection is still needed because of the safety. The testing arrangement may further be configured to receive the climate hood for controlling the environmental properties inside the hood. The climate hood may also have the splinter protection. Hence, many kinds of the removable hoods having different technical properties may be used in the same transportable testing arrangement according to the actual needs.

In an embodiment, the at least a part of the at least one wall of the removable hood mounted on the base is configured meet all the requirements of the removable hoods having the different technical properties. Hence, the wall or a part of the wall of the hood mounted on the base may be configured to meet requirements of the splinter protection and the climate hood, for example. Then there is no needs to change the wall or the part of the wall of the hood mounted on the base when changing the hood having different technical properties.

There are may technical advantages with the above mentioned feature. The transportable testing arrangement may be ordered with the two removable hoods wherein a first hood may be splinter protected and a second one climate hood having also the splinter protection. The hood used in the testing may be selected according to testing going to be done. For example, if the environmental properties are needed, the clime hood is assembled to the testing arrangement and if not, the hood having only the splinter protection may be selected. Another example, three transportable testing arrangement may be ordered with three hoods wherein two of the hoods are only the splinter protected and one of the hoods is the climate hood (may also have the splinter protection). Then hoods may be changed between the testing arrangement according to the testing needs. It also possible to order three transportable testing arrangements with three hoods having only the splinter protection and further order one climate hood. Then the splinter protected hoods may be used in all the testing arrangement if there are no needs to control the environmental properties. The climate hood is used when the need to control the environmental properties in one of the testing arrangements exists.

In an embodiment, the transportable testing arrangement further comprises wheels for moving the arrangement. The wheels may be in the frame. The wheels may be configured to be turned on when needed and turned off when not needed. In the turned off position the wheels may be lifted up, for example.

In an embodiment, the transportable testing arrangement is coupled with a controlling unit configured to control the testing of the electric component. In an embodiment, the transportable testing arrangement comprises the controlling unit configured to control the testing of the electric component. The controlling unit may be used for controlling the testing equipment, the electric component to be tested and/or the climate hood, for example. In an embodiment, a plurality of the transportable testing arrangements are controlled with one controlling unit. Then a plurality of the testing arrangements may be controlled, for example, from one controlling room.

The next example describes the benefits of the transportable testing arrangement. The transportable testing arrangement provides a solution for extending the testing capacity effectively. The transportable testing arrangements is configured to be transported to the testing facilities as such, coupled with the external connection(s) (electricity, water etc..) and it is then ready to use. It may comprise all the essential component to perform the testing. Making of specific foundations for the testing arrangement are not necessarily needed. Because of the structure of the transportable testing arrangement wherein the vibration between the base and the frame are damped, the test arrangement can be just placed on the floor of the testing facility without any complicated mounting activities. Testing can be started when the external connection(s) are done. It may also be possible to add the testing arrangement into the foundations of a building. Then the frame may be integrated into the floor, for example.

In addition, the transportable testing arrangement is configured to receive a plurality of the removable hoods having different technical properties as described above in this application. This feature enables adjusting of the testing arrangement for different kind of testing procedures according to the needs. The structure of the removable hood allows also effortless changing of the hood since at least a part of the at least one wall of the hood is mounted on the base having the inlets used for leading through the coupling between the testing equipment and the electric component.

It will be obvious to a person skilled in the art that, as technology advances, the inventive concept can be implemented in various ways. The invention and its embodiments are not limited to the example embodiments described above but may vary within the scope of the claims.

## Claims

1. A transportable testing arrangement, comprising:
a testing area configured to receive an electric component to be tested;
a removable hood configured to cover the testing area;
testing equipment for testing the electric component;
a base on which the testing area, the removable hood and at least part of the testing equipment are arranged; and
a frame on which the base is arranged,
wherein the base further comprises at least a part of at least one wall of the removable hood having at least a part of one or more inlets to couple the testing equipment with the electric component.

2. The transportable testing arrangement of claim 1, wherein the base further comprises at least a part of two walls of the removable hood such that each wall has at least a part of one or more inlets to couple the testing equipment with the electric component.

3. The transportable testing arrangement of any preceding claim, wherein the base is mounted on the frame by one or more suspension elements configured to enable movement of the base in relation to the frame.

4. The transportable testing arrangement of claim 3, wherein the one or more suspension elements comprise an air spring.

5. The transportable testing arrangement of any preceding claims, wherein the arrangement is configured to receive one or more locking elements configured to prevent movement of the base in relation to the frame in transportation.

6. The transportable testing arrangement of claims 1 - 4 wherein the arrangement comprises the one or more locking elements configured to prevent movement of the base in relation to the frame in transportation.

7. The transportable testing arrangement of any preceding claims, wherein the one or more inlets are configured to receive a mechanical transmission element from the testing equipment to the electric component.

8. The transportable testing arrangement of any preceding claims, wherein the one or more inlets are configured to receive a sensor element from the testing equipment to the electric component.

9. The transportable testing arrangement of any preceding claims, wherein the arrangement further comprises one or more lifting points for coupling lifting means to the arrangement.

10. The transportable testing arrangement of any preceding claims, wherein the removable hood comprises a climate hood.

11. The transportable testing arrangement of any preceding claims, wherein the removable hood comprises a projectile protection.

12. The transportable testing arrangement of any preceding claims, wherein the removable hood comprises a fire protection.

13. The transportable testing arrangement of any preceding claims, wherein the removable hood is movably coupled with the base.

14. The transportable testing arrangement of any preceding claims, wherein the removable hood comprises one or more fasteners to fasten the removable hood with the at least a part of the at least one wall of the removable hood placed on the base.

15. The transportable testing arrangement of any preceding claims, wherein the removable hood comprises one or more lifting points for coupling lifting means to the removable hood.

16. The transportable testing arrangement of any preceding claims, wherein the arrangement comprises means for adjusting distance between the electric component and the testing equipment.
